## Europäisches Patentamt
## European Patent Office
## Office européen des brevets

(11) Veröffentlichungsnummer: **0 009 598**
.A1

(12) # EUROPÄISCHE PATENTANMELDUNG

(21) Anmeldenummer: 79103074.5

(22) Anmeldetag: 21.08.79

(51) Int. Cl.³: **G 11 C 19/28**
G 11 C 27/02, H 01 L 27/10

(30) Priorität: 28.09.78 DE 2842285

(43) Veröffentlichungstag der Anmeldung:
16.04.80 Patentblatt 80/8

(84) Benannte Vertragsstaaten:
FR GB NL

(71) Anmelder: SIEMENS AKTIENGESELLSCHAFT Berlin
und München
Postfach 22 02 61
D-8000 München 22(DE)

(72) Erfinder: Grüter, Otto, Dr.rer.nat.
Berchemstrasse 17
D-8033 Krailling(DE)

(54) **Ladungsverschiebespeicher in Seriell-Parallel-Seriell-Organisation.**

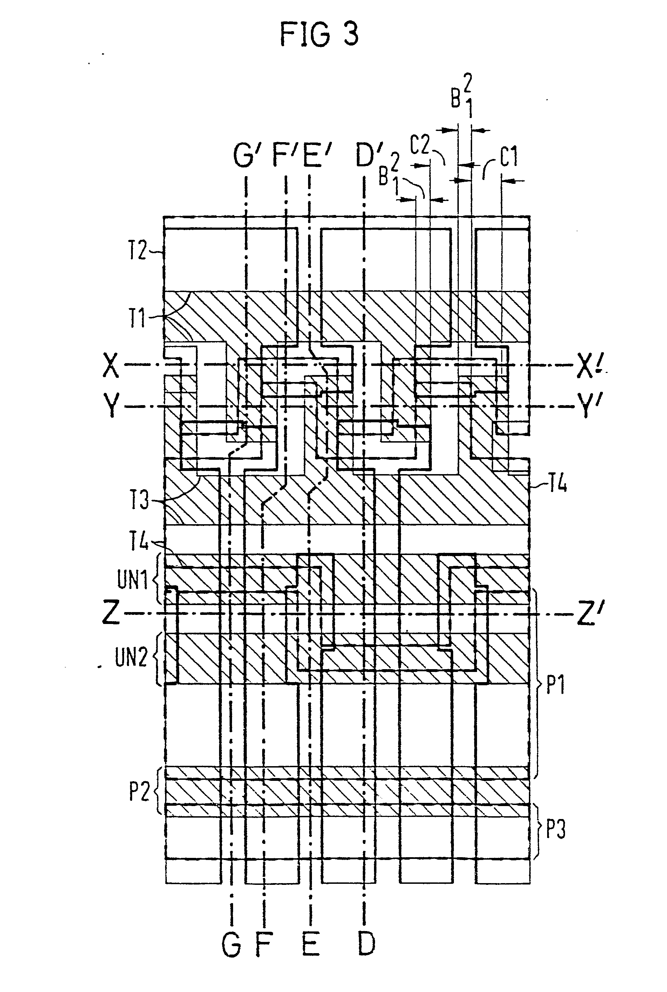

(57) Die Erfindung betrifft einen auf einem Chip integrierten Ladungsverschiebespeicher mit einer Einlesekette aus abwechselnd hintereinander angeordneten, jeweils über Taktleitungen ansteuerbaren ersten und zweiten Ladungsverschiebeelementen aus Speicher- und Verschiebeelektrode und einem Feld von Parallelketten von Ladungsverschiebeelementen, in die entweder allein aus den ersten oder allein aus den zweiten Ladungsverschiebeelementen der Einlesekette Informationen kennzeichnende Ladungen übernommen werden und mit einer entsprechend der Einlesekette aufgebauten und über Taktleitungen betriebenen Auslesekette, wobei mindestens im Bereich der seriellen Ein- und Ausleseketten des Chips jeweils die gleichartigen Elektroden (T2, T4; T1, T2) der Ladungsverschiebeelemente (LE) der Ein- /Auslesekette (EK, AK) gemeinsam mit den zugehörigen ansteuernden Taktleitungen aus einem durchgehenden Leitungsband bestehen. (Fig. 3)

./...

0009598

SIEMENS AKTIENGESELLSCHAFT       Unser Zeichen
Berlin und München               VPA   78 P 2 0 5 3 EUR

Ladungsverschiebespeicher in Seriell-Parallel-Seriell-
Organisation

Die Erfindung betrifft einen auf einem Chip integrierten
Ladungsverschiebespeicher mit einer Einlesekette aus abwechselnd hintereinander angeordneten, jeweils über Taktleitungen ansteuerbaren ersten und zweiten Ladungsverschiebeelementen mit Speicher- und Verschiebeelektroden
und mit einem Feld von Parallelketten von Ladungsverschiebeelementen, in die entweder allein aus den ersten
oder allein aus den zweiten Ladungsverschiebeelementen
der Einlesekette die Informationen kennzeichnenden Ladungen übernommen werden, und mit einer entsprechend der
Einlesekette aufgebauten Auslesekette.

Ladungsverschiebespeicher in sogenannter verdichteter
Seriell-Parallel-Seriell-Technik, wie sie z.B. in der
deutschen Offenlegungsschrift 2 551 797 bzw. 2 518 017
beschrieben werden, bestehen aus einer seriell angeordneten Einlesekette aus Ladungsverschiebeelementen, einer

MM 1 Sur / 26.9.1978

jeder Speicherelektrode dieser Seriellkette zugeordneten Parallelkette aus Ladungsverschiebeelementen und einer weiteren seriell angeordneten Auslesekette.

Durch eine derartige Organisation kann eine sehr hohe Speicherdichte erzielt werden.

Wie aus den zitierten Offenlegungsschriften ersichtlich, ist das Taktprogramm zur Ansteuerung eines derartig organisierten Speichers relativ kompliziert. Da nur unter jeder zweiten Speicherelektrode Information enthalten ist, muß die serielle Kette zweimal eingelesen werden und es muß die Information zweimal in das Parallelfeld übernommen werden. Bei der Übernahme steht die Information das erstemal unter den ungeraden Speicherelektroden, das zweitemal unter den geraden. Damit muß die zweite Übernahme um einen Schiebetakt versetzt erfolgen. Das heißt, die Übernahmetakte kommen nicht in gleichen Abständen sondern sind etwas gegeneinander versetzt. Die Erzeugung derartiger nichtperiodischer Übernahmetakte ist aber insgesamt recht aufwendig.

Zur Erzeugung eines Ladungsverschiebespeichers in verdichteter Seriell-Parallel-Seriell-Organisation mit hoher Speicherdichte, der in einfacher und kostengünstiger Weise mit einem streng periodischen Taktprogramm angesteuert werden kann, wurde vorgeschlagen, jedem ersten oder zweiten Ladungsverschiebeelement der Ein- und Auslesekette eine Gruppe von mindestens zwei mit Übernahme- bzw. Übergabeelektroden versehene, benachbarte Parallelketten von Ladungsverschiebeelementen zuzuordnen.

Durch eine derartige Speicherorganisation wird die die Information definierende Ladung immer aus den gleichen Speicherelektroden der Einlesekette übernommen und abwechselnd in zwei benachbarte Parallelketten eingegeben bzw. aus zwei benachbarten Parallelketten immer in die gleiche Speicherelektrode der Auslesekette übergeben.

Ladungsverschiebespeicher mit der angegebenen Organisationsform können wie alle derartigen Ladungsverschiebespeicher als Zweiphasen-Ladungsverschiebespeicher oder Vierphasen-Ladungsverschiebespeicher ausgelegt sein. Es ist ebenso möglich, Vierphasen-Ladungsverschiebespeicher in Zweiphasen-Betrieb zu betätigen. Die im folgenden getätigten Überlegungen gelten für einen Vierphasen-Ladungsverschiebespeicher, der z.B. im Zweiphasen-Betrieb betätigt wird, eine Betriebsweise, bei der jede zweite Elektrode (Speicherelektrode) zeitgleich mit der benachbarten (Verschiebeelektrode) angesteuert wird. Als Ladungsverschiebeelement wird dabei ein Element definiert, das sich aus Speicher- und Verschiebeelektrode zusammensetzt. Selbstverständlich gelten die analogen Überlegungen auch für einen echten Zweiphasen-Ladungsverschiebespeicher; in diesem Fall werden als Ladungsverschiebeelemente die elektrisch verbundenen Verschiebe- und Speicherelektroden definiert, oder für einen reinen Vierphasen-Betrieb, bei dem die Verschiebe- und Speicherelektroden getrennt angesteuert werden.

Bei den bisher bekannten Ladungsverschiebespeichern mit Seriell-Parallel-Seriell-Organisation in Doppelsiliziumtechnologie wurden die vier Takte der Seriellketten sämtlich von der Außenseite des Speicherfeldes zugeführt. Das benötigt auf dem Chip viel Platz und je Periode einer Seriellkette zwei Kontakte und zwar einen von Polysilizium-1 (Speicherelektrode) und von Polysilizium-2 (Verschiebeelektrode) zu jeweils einer zusätzlichen Metallbahn.

Der ladungsübertragende Kanal wurde bei den verdichteten Seriell-Parallel-Seriell-Speicherbausteinen beim Übergang von der Seriellkette ins Parallelfeld und umgekehrt flaschenhalsförmig eingeengt.

Derartige Einengungen können die Ladungsverluste schädlich vergrößern. Außerdem wird durch diese Stelle das Rastermaß und damit die Packungsdichte der Seriellketten bestimmt.

Aufgabe der Erfindung ist es, für einen Ladungsverschiebespeicher in Seriell-Parallel-Seriell-Organisation ein Layout bereitzustellen, mit dem in einfacher Weise die Versorgung der Seriellketten mit Ansteuertakten ohne besondere metallische Taktleitungen bewerkstelligt werden kann.

Diese Aufgabe wird gemäß der Erfindung dadurch gelöst, daß mindestens im Bereich der seriellen Ein- und Ausleseketten des Speicherfeldes jeweils die gleichartigen Elektroden der Ladungsverschiebeelemente der Ein- und Auslesekette gemeinsam mit den zugehörigen Taktleitungen aus einem durchgehenden Polysilizium-Leitungsband bestehen.

Die Speicherelektroden der Ladeverschiebeelemente der Ein- und Auslesekette weisen dabei die Form von zwei parallel verlaufenden, kammförmig ineinandergreifenden, die Bereiche der Ein- und Auslesekette des Speicherfeldes seitlich abgrenzenden Bänder auf.

Die Verschiebeelektroden der Ladungsverschiebeelemente der Ein- und Auslesekette weisen in einer Ausführungsform der Erfindung ebenfalls die Form von zwei parallel verlaufenden, kammförmig ineinandergreifenden Bändern auf, die im Bereich der Verzahnungen der Speicherelektroden parallel zu den Speicherelektroden angeordnet sind.

Bei einer weiteren vorteilhaften Ausführungsform der Erfindung haben die Verschiebeelektroden die Form von zwei parallel verlaufenden, im Bereich der Verzahnung der Speicherelektroden angeordneten Bänder.

Bei den angegebenen vorteilhaften Layouts eines verdichteten Seriell-Parallel-Seriell-Speicherfeldes sind für die Taktzuführungen zu den Seriellketten keine besonderen metallischen Taktleitungen notwendig, da die Verschiebe- und Speicherelektroden der Seriellketten selbst als Taktleitungen dienen. Damit entfallen die metallischen Leiterbahnen und sämtliche technologisch empfindlichen Kontakte zwischen Silizium und Metall. Ein weiterer Vorteil ist der geringe Platzaufwand und in der ersten Ausführungsform der Erfindung das Fehlen von flaschenhalsförmigen Einschnürungen des ladungstragenden CCD-Kanals.

Die Erfindung wird nachstehend anhand der in den Zeichnungen dargestellten Ausführungsformen erläutert. Es zeigen:

Fig. 1    eine schematische Darstellung des Layouts eines bekannten Ladungsverschiebespeichers in verdichteter Seriell-Parallel-Seriell-Organisation,

Fig. 2    ein Blockschaltbild eines Ladungsverschiebespeichers in Seriell-Parallel-Seriell-Organisation mit streng periodischer Taktansteuerung,

Fig. 3    eine schematische Darstellung des Layouts des Ladungsverschiebespeichers gemäß Fig. 2,

Fig. 4 und Fig. 5    Schnittzeichnungen des Ladungsverschiebespeichers gemäß Fig. 3, und

Fig. 6    eine schematische Darstellung des Layouts eines Ladungsverschiebespeichers mit neanderförmiger Struktur.

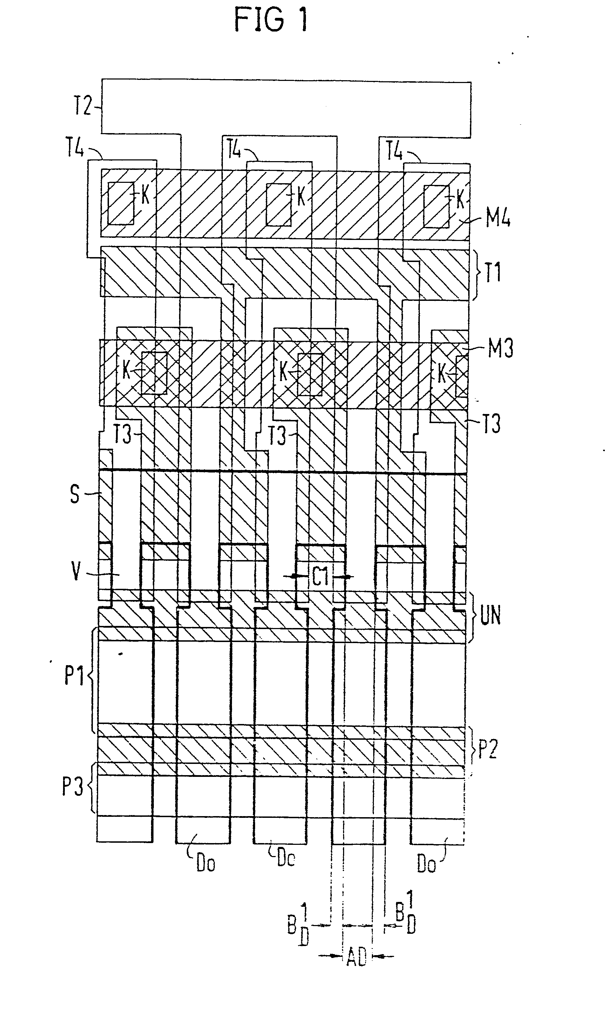

Bei dem in der Fig. 1 im Layout dargestellten Ladungsverschiebespeicher in sogenannter verdichteter Seriell-Parallel-Seriell-Technik, wie er in der deutschen Offenlegungsschrift 2 551 797 bzw. 2 518 017 beschrieben wird, ist unter jeder Speicherelektrode der Seriellkette eine Parallelkette aus Ladungsverschiebeelementen angeordnet. Das dargestellte Layout der Fig. 1 beschränkt sich dabei im wesentlichen auf die Seriellkette mit ihren vier Taktleitungen T1 bis T4 und ihren zugeordneten Elektroden und der Parallelkette mit der Übernahmeelektrode UN und den ersten Elektroden P1 bis P3 des eigentlichen Speicherfeldes. Die ebenfalls notwendige serielle Auslesekette ist in analoger Weise aufgebaut.

Die Seriellkette besteht im wesentlichen aus den aus Polysilizium-1 bestehenden Speicherelektroden T2 und T4 und den aus Polysilizium-2 bestehenden Verschiebeelektroden T1 und T3 (linksläufig schraffiert dargestellt). Die Speicherelektrode T2 ist dabei bis an den oberen Rand des Speicherfeldes herausgeführt und dient gleichzeitig als Taktleitung. Auch die Verschiebeelektrode T1 aus Polysilizium-2 ist durchgehend ausgebildet. Die Speicherelektrode T4 und die Verschiebeelektrode T3 müssen über besondere Metallbänder M4 und M3 (rechtsläufig schraffiert) und den zugeordneten Kontaktflächen K mit den erforderlichen Ansteuertakten versorgt werden.

An die Seriellkette schließen sich die Parallelketten mit der Übernahmeelektrode UN und der Verschiebeelektrode (linksläufig schraffiert) aus Polysilizium-2 und den Speicherelektroden P1 und P3 aus Polysilizium-1 an. Die einzelnen Parallelketten sind voneinander durch Schichten aus Dickoxid DO getrennt.

Wie aus der Fig. 1 ersichtlich, verengt sich der CCD-Kanal beim Übergang V von der Seriellkette S ins Parallelfeld und umgekehrt flaschenhalsförmig. Diese Stelle V bestimmt das Rastermaß der Seriellkette und damit die Packungsdichte der gesamten Anordnung. So ergibt sich als Rastermaß für den Flaschenhals 2x $(A^D + 2B_D^1 + C1)$. AD bezeichnet dabei das minimale Strukturmaß (Abstand zwischen zwei Dickoxidbereichen) und $B_D^1$ jene Überlappung von Polysilizium-1 über die Dickoxidbereiche, die notwendig ist, um Fehler infolge der unvermeidbaren Verjustierung der Masken auszuschließen. C1 bezeichnet den Minimalabstand von zwei Polysilizium-1-Bahnen.

Bei einem entsprechend der Fig. 1 aufgebauten Seriell-Parallel-Seriell-Speicherbaustein in verdichteter Organisation steht beim Einlesen in den Speicherbaustein nur unter jeder zweiten Speicherelektrode Information, so daß die serielle Kette zweimal eingelesen werden und zweimal in das Parallelfeld übernommen werden muß. Bei der Übernahme steht die Information das erstemal unter den ungeraden Speicherelektroden und das zweitemal unter den geraden. Bei der Übernahme muß also ein Schiebetakt versetzt erfolgen. Ein derartiger Speicheraufbau macht das Taktprogramm ungerade, dh., es kann nicht mehr streng periodisch aufgebaut werden.

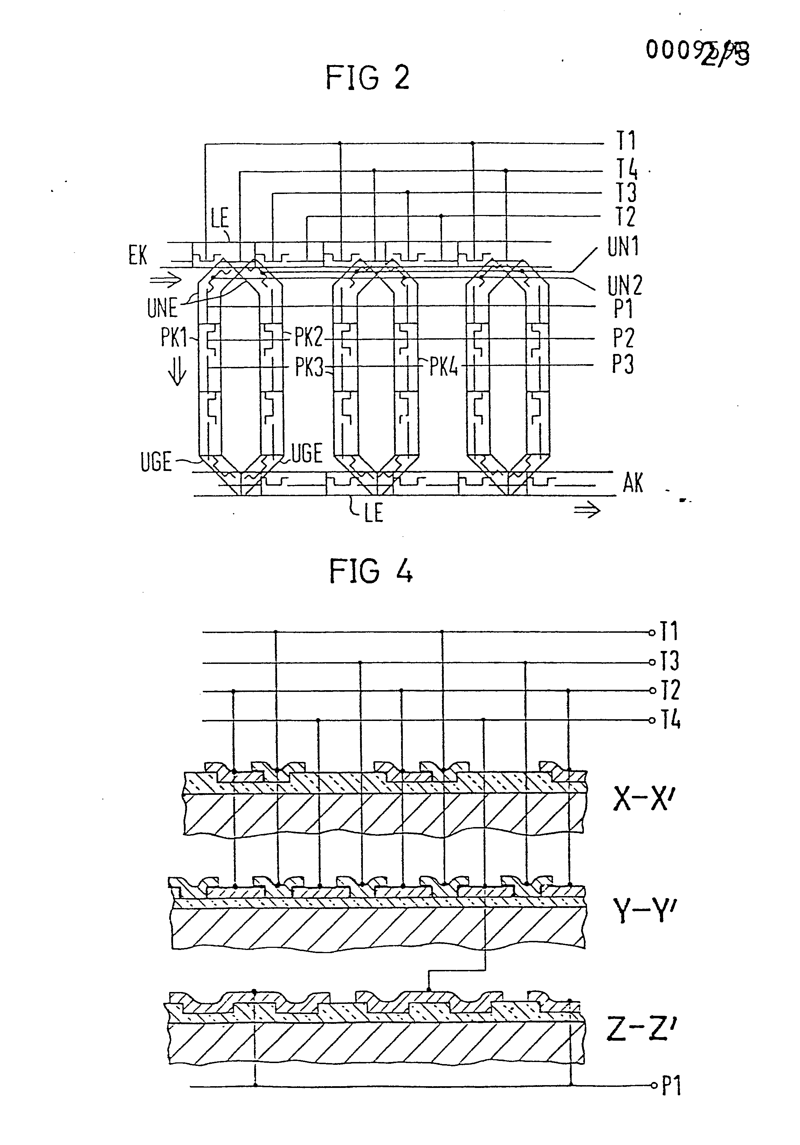

Ordnet man gemäß der Fig. 2 jedem ersten Ladungsverschiebeelement LE der Ein- und Auslesekette EK, AK mindestens eine Gruppe von zwei mit Übernahme- bzw. Übergabeelektroden UNE, UGE versehene benachbarte Parallelketten PK1 und PK2 von Ladungsverschiebeelementen zu, so wird das zugehörige Taktprogramm für die Übernahmetakte UN1 und UN2 streng periodisch. Das bedeutet, der Übernahmetakt UN2 liegt exakt in der Mitte zwischen dem Übernahmetakt UN1.

Mit einer derartigen Organisation ist nun ein Layout entsprechend der Darstellung der Fig. 3 möglich, wobei allerdings zum Unterschied in der Fig. 2 die Informationsladungen von rechts eingespeist werden. Dabei bestehen mindestens im Bereich der seriellen Ein- und Ausleseketten des Speicherfeldes jeweils die gleichartigen Elektroden für Ladungsverschiebeelemente der Ein- und Auslesekette gemeinsam mit den zugehörigen Taktleitungen aus einem durchgehenden Leitungsband (T1 bis T4).

Die Polysilizium-1-Speicherelektroden T2 und T4 der Ladungsverschiebeelemente der Ein- und Auslesekette haben dabei die Form von zwei parallel verlaufenden, kammförmig ineinandergreifenden, die Bereiche der Ein- und Auslesekette seitlich begrenzenden Bändern. Auch die Polysilizium-2-Speicherelektroden T1 und T3 weisen die Form von zwei parallel verlaufenden, kammförmig ineinandergreifenden Bändern auf. Sie sind dabei im Bereich der Verzahnungen der Speicherelektroden T2 und T4 parallel zu den Speicherelektroden angeordnet. Damit entfallen innerhalb der Taktversorgung die Metallbahnen und damit sämtliche technologisch empfindlichen Kontakte. Es ergibt sich damit ein beträchtlicher Platzgewinn. Wie aus der Fig. 3 ersichtlich, ergeben sich keinerlei flaschenhalsförmige Verengungen des CCD-Kanals mehr, das Rastermaß wird demnach allein durch die Seriellkette selbst bestimmt. Und zwar ergibt sich das Rastermaß zu $R = 2x (C2+2B_1^D+C1)$. C2 bezeichnet dabei den minimalen Abstand zwischen den beiden Elektroden aus Polysilizium-2 (Verschiebeelektroden T1 und T3).C1 den minimalen Abstand zwischen zwei Elektroden aus Polysilizium-1 (Speicherelektroden T2, T4) und $B_1^2$ die notwendige Überlappung von Polysilizium-2 über Polysilizium-1.

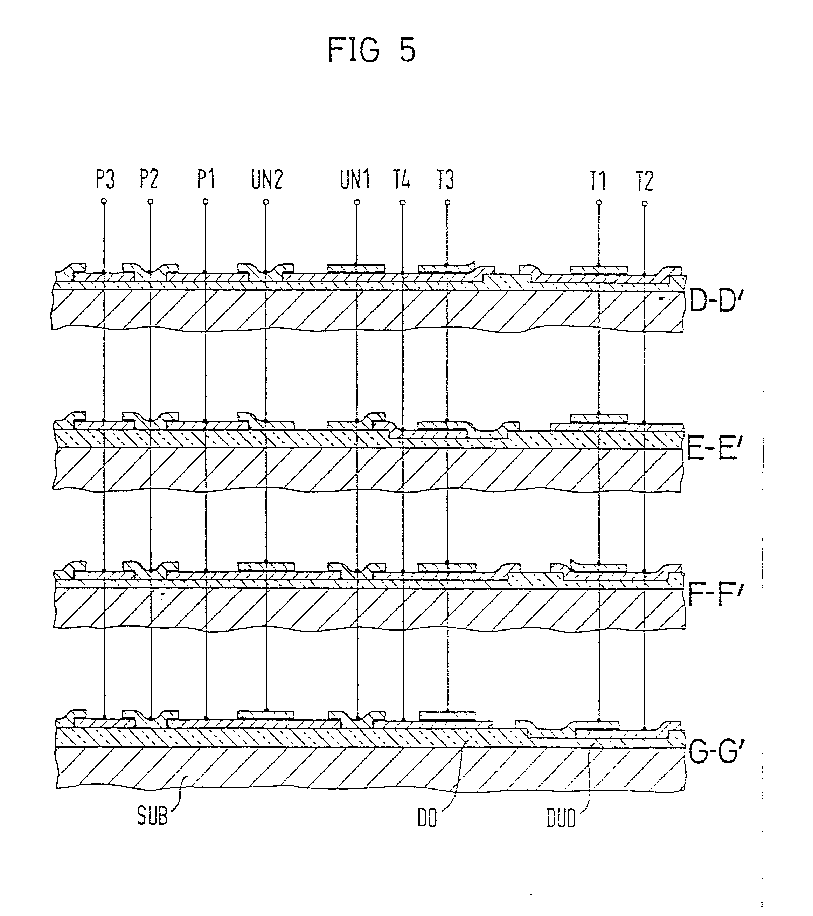

Der strukturelle Aufbau der Schaltungsanordnung gemäß der Fig. 3 ergibt sich aus den Schnittdarstellungen der Fig. 4 und 5 mit ihren im einzelnen bezeichneten Schnittlinien.

- 9 -     VPA   78 P 2068 EUR

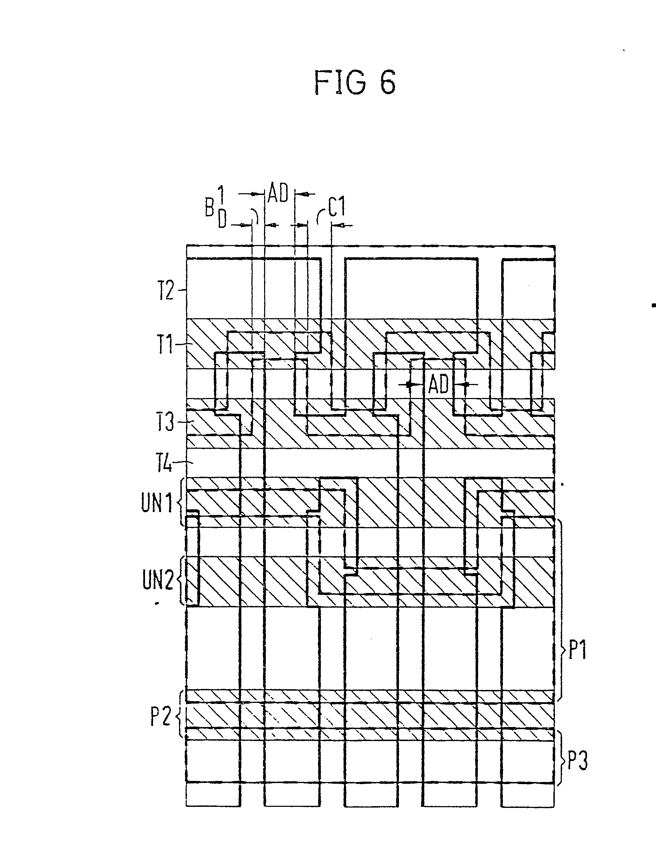

Eine weitere Reduktion des Platzbedarfes auf dem Chip ergibt sich durch das in der Fig. 6 dargestellte Layout, in dem allerdings wieder Minimalbreiten AD des CCD-Kanales vorkommen. Hier haben die Verschiebeelektroden T1 und T3 die Form von zwei parallel verlaufenden, im Bereich der Verzahnung der Speicherelektroden T2 und T4 angeordneten Bändern. Durch den daraus resultierenden mäanderförmigen Verlauf des CCD-Kanals der Seriellkette wird das Rastermaß allein durch die Minimalmaße der Oxidätzung und der Polysilizium-1-Ebene (Speicherelektroden T2 und T4) bestimmt. Die bezüglich Ätzung und Justierung kritischere Polysilizium-2-Ebene spielt in Bezug auf die Minimalabmessungen keine Rolle mehr, so daß sich für das Rastermaß ergibt: $R = 2x \ (AD+2B_D^1+C1)$.

Bezugszeichenliste

| | |
|---|---|
| T1, T2, T3, T4 | Taktleitungen (Elektroden) |
| UN | Übernahmeelektrode |
| P1 bis P3 | Elektroden der Parallelkette |
| M4, M3 | Metallbänder |
| K | Kontaktflächen |
| DO | Dickoxid |
| V | Übergang Seriellkette-Parallelfeld |
| S | Seriellkette |
| $B_D^1$ | Überlappung Polysilizium-1 über Dickoxidbereiche |
| AD | Minimales Strukturmaß |
| C1 | Minimalabstand von zwei Polysilizium-1-Bahnen |
| C2 | Minimalabstand von zwei Polysilizium-2-Bahnen |
| LE | Ladungsverschiebeelement |
| EK | Einlesekette |
| AK | Auslesekette |
| UNE | Übernahmeelektroden |
| UGE | Übergabeelektroden |
| PK1, PK2 | Benachbarte Parallelketten |
| UN1 | Übernahmetakte |
| UN2 | Übergabetakte |
| R | Rastermaß |
| $B_1^2$ | Überlappung Polysilizium-2 über Polysilizium-1 |
| DUO | Dünnes Oxid |
| SUB | Substrat |

Patentansprüche

1. Auf einem Chip integrierter Ladungsverschiebespeicher mit einer Einlesekette aus abwechselnd hintereinander angeordneten, jeweils über Taktleitungen ansteuerbaren ersten und zweiten Ladungsverschiebeelementen aus Speicher- und Verschiebeelektrode und einem Feld von Parallelketten von Ladungsverschiebeelementen, in die entweder allein aus den ersten oder allein aus den zweiten Ladungsverschiebeelementen der Einlesekette Informationen kennzeichnende Ladungen übernommen werden und mit einer entsprechend der Einlesekette aufgebauten und über Taktleitungen betriebenen Auslesekette, d a d u r c h g e k e n n z e i c h n e t , daß mindestens im Bereich der seriellen Ein- und Ausleseketten des Chips jeweils die gleichartigen Elektroden (T2, T4; T1, T3) der Ladungsverschiebeelemente (LE) der Ein-/Auslesekette (EK, AK) gemeinsam mit den zugehörigen, ansteuernden Taktleitungen aus einem durchgehenden Leitungsband bestehen.

2. Ladungsverschiebespeicher nach Anspruch 1, d a - d u r c h g e k e n n z e i c h n e t , daß die Speicherelektroden (T2, T4) der Ladungsverschiebeelemente (LE) der Ein- und Auslesekette die Form von zwei parallel verlaufenden, kammförmig ineinandergreifenden, die Bereiche der Ein- und Auslesekette auf dem Chip seitlich begrenzenden Bänder (T2, T4) aufweisen.

3. Ladungsverschiebespeicher nach Anspruch 2, d a - d u r c h g e k e n n z e i c h n e t , daß die Verschiebeelektroden (T1, T3) der Ladungsverschiebeelemente der Ein- und Auslesekette die Form von zwei parallel verlaufenden, kammförmig ineinandergreifenden Bändern (T1, T3) aufweisen, die im Bereich der Verzahnungen der Speicherelektroden (T2, T4) parallel zu den Speicherelektroden angeordnet sind.

4. Ladungsverschiebespeicher nach Anspruch 2, d a - d u r c h   g e k e n n z e i c h n e t , daß die Ver- schiebeelektroden (T1, T3) die Form von zwei parallel verlaufenden, im Bereich der Verzahnungen der Speicherelektrode angeordneten Bändern aufweist.

5. Ladungsverschiebespeicher nach einem der Ansprüche 2 oder 3, d a d u r c h   g e k e n n z e i c h n e t , daß bei einem 2-Phasen-Betrieb die einander zugeordneten Elektroden (T1, T2; T3, T4) kapazitiv gekoppelt und im wesentlichen übereinander gestapelt verlaufen.

FIG 1

# FIG 2

T1
T4
T3
T2

LE

EK

UN1
UN2
UNE
P1
PK1
PK2
P2
PK3
PK4
P3

UGE    UGE

AK

LE

# FIG 4

T1
T3
T2
T4

X–X'

Y–Y'

Z–Z'

P1

FIG 3

FIG 5

P3  P2  P1  UN2      UN1  T4  T3        T1  T2

D-D'

E-E'

F-F'

G-G'

SUB                           D0        DU0

FIG 6

## EUROPÄISCHER RECHERCHENBERICHT

**0009598**
Nummer der Anmeldung

EP 79 10 3074

Europäisches
Patentamt

| | EINSCHLÄGIGE DOKUMENTE | | KLASSIFIKATION DER ANMELDUNG (Int.Cl. 3) |
|---|---|---|---|
| Kategorie | Kennzeichnung des Dokuments mit Angabe, soweit erforderlich, der maßgeblichen Teile | betrifft Anspruch | |
| | <u>US - A - 4 117 546</u> (IBM) <br><br> * Spalte 4, Zeile 20 bis Spalte 5, Zeile 45; Spalte 6, Zeile 55 bis Spalte 7, Zeile 8; Spalte 7, Zeile 66 bis Spalte 8, Zeile 13, Figuren 1,2,5,7 * <br><br> -- | 1,2 | G 11 C 19/28 27/02 <br> H 01 L 27/10 |
| | <u>US - A - 3 967 254</u> (R.C.A.) <br><br> * Spalte 1, Zeile 52 - Spalte 3, Zeile 66; Figuren 1,2 * | 1,2 | |
| D | & DE - A - 2 551 797 <br><br> -- | | **RECHERCHIERTE SACHGEBIETE (Int. Cl. 3)** <br><br> G 11 C 19/28 27/02 <br> H 01 L 27/10 |
| | <u>NL - A - 73 16277</u> (TEXAS) <br><br> * Seite 4, Zeile 32 - Seite 7, Zeile 3; Figuren 1,2 * <br><br> & DE - A - 2 362 703 <br><br> -- | 1,2 | |
| | IEE EUROPEAN SOLID-STATE CIRCUITS, CONFERENCE, 2-5 September 1975, IEE, London, GB, GOTTLER et al.: "CCD Memory circuits of high bit density", Seiten 76,77 <br><br> * Seite 76, Zeilen 14-23; Figur 1 * <br><br> -- | 1,2 | **KATEGORIE DER GENANNTEN DOKUMENTE** <br><br> X: von besonderer Bedeutung <br> A: technologischer Hintergrund <br> O: nichtschriftliche Offenbarung <br> P: Zwischenliteratur |
| A | ELECTRONICS, Vol. 51, Nr. 13, 22. Juni 1978, New York, US, THREEWITT: "CCD's bring solid-state benefits to bulk storage for computers" , Seiten 133-137 <br><br> ./. | 1 | T: der Erfindung zugrunde liegende Theorien oder Grundsätze <br> E: kollidierende Anmeldung <br> D: in der Anmeldung angeführtes Dokument <br> L: aus andern Gründen angeführtes Dokument |
| | | | &: Mitglied der gleichen Patentfamilie, übereinstimmendes Dokument |

Der vorliegende Recherchenbericht wurde für alle Patentansprüche erstellt.

| Recherchenort | Abschlußdatum der Recherche | Prüfer |
|---|---|---|
| Den Haag | 09-01-1980 | V.SCHMIDT |

EPA form 1503.1 06.78

**Europäisches Patentamt**

# EUROPÄISCHER RECHERCHENBERICHT

| EINSCHLÄGIGE DOKUMENTE | | | KLASSIFIKATION DER ANMELDUNG (Int.Cl. 3) |
|---|---|---|---|
| Kategorie | Kennzeichnung des Dokuments mit Angabe, soweit erforderlich, der maßgeblichen Teile | betrifft Anspruch | |
| | * Figuren 1,3,4 * | | |
| | -- | | |
| A | US - A - 3 913 077 (HUGHES) | 1 | |
| A | US - A - 4 007 446 (HONEYWELL) | 1 | |
| A | IEEE JOURNAL OF SOLID-STATE CIRCUITS, Vol. SC9, Nr. 6, Dezember 1974, New York, US, KRAMBECK et al.: "A 4160-Bit C4D serial Memory", Seiten 436-443 | 1 | |
| A | US - A - 3 763 480 (R.C.A.) | 1 | **RECHERCHIERTE SACHGEBIETE (Int. Cl. 3)** |
| A | US - A - 4 065 756 (BURROUGHS) | 1 | |
| A | US - A - 4 024 514 (HONEYWELL) | 1 | |
| A | US - A - 3 944 990 (INTEL) | 1 | |
| A | US - A - 3 885 167 (BELL) | 1 | |
| A | US - A - 3 953 837 (TEXAS) | 1 | |
| DA | DE - A - 3 518 017 (SIEMENS) | 1 | |
| A | US - A - 3 889 245 (TEXAS) | 1 | |
| | ---- | | |

EPA Form 1503.2  06.78